# FASCICULE DE BREVET EUROPEEN

(11) **EP 2 345 158 B1**
(45) Date de publication et mention de la délivrance du brevet: **01.05.2019**
(21) Numéro de dépôt: 09747878.8
(22) Date de dépôt: 01.10.2009
(51) Int. Cl.: H03K 17/12, H03K 17/082, H02H 3/08

(54) **DISJONCTEUR ELECTRONIQUE EN TRANCHE ET INSTALLATION LE COMPORTAN**
SEGMENTALER ELEKTRONISCHER UNTERBRECHERSCHALTER UND INSTALLATION DAMIT
SEGMENTAL ELECTRONIC CIRCUIT BREAKER AND INSTALLATION COMPRISING SAME

(30) Priorité: 01.10.2008 FR 0805433
(43) Date de publication de la demande: 20.07.2011
(73) Titulaire: Novatec SA, 82000 Montauban (FR); Carrillo, Jean-Jacques, 82000 Montauban (FR)
(72) Inventeur: CARRILLO, Jean-Jacques, F-82000 Montauban (FR)
(74) Mandataire: Ipside
(86) Numéro de dépôt international: PCT/FR2009/001174
(87) Numéro de publication internationale: WO 2010/037936

(56) Documents cités:
- EP-A2- 0 517 261
- EP-A2- 0 664 613
- DE-A1- 10 345 556
- US-A- 5 856 711
- US-A1- 2004 252 430
- US-A1- 2007 103 833
- US-B1- 6 208 041

## Description

### Domaine technique

La présente invention est du domaine des matériels utilisés dans les installations électriques. Plus particulièrement l'invention est du domaine des matériels utilisés pour assurer les fonctions de protection de l'installation contre les surintensités, les surtensions, les sous tensions, les défauts différentiels et autres défauts électriques et se rapporte à un nouveau type de disjoncteur électronique.

### Etat de la technique antérieure.

On connaît de l'état de la technique des disjoncteurs électroniques. Ces disjoncteurs présentent l'avantage sur les disjoncteurs électromécaniques d'être réarmables à volonté et ce à distance, d'intégrer la fonction de relais en ce sens qu'ils peuvent être ouverts ou fermés à distance.

Ces disjoncteurs sont utilisés dans divers domaines et notamment dans le domaine des transports et autres. C'est ainsi que l'on connaît leur utilisation dans le domaine de l'aéronautique pour assurer la protection des circuits électriques des avions.

Certaines cartes sont déjà équipées de plusieurs disjoncteurs électroniques comme décrit dans les brevets référencés « US 2007/103833 A1 » (HARRIS EDWIN J IV [US]) du 10 mai 2007 (2007-05-10) d'une part et « US 5 856 711 A » (KATO AKIRA [JP] ET AL). Ces cartes ne sont pas utilisables en l'état pour une mise en parallèle car le déclenchement d'un disjoncteur ne peut se faire qu'à partir de la connaissance de l'ensemble des courants traversant chaque élément de disjoncteur qui alimente cette charge. L'homme de l'art ne met pas de disjoncteurs en parallèle, ne sachant pas a priori quel sera l'écart de courant entre ces différents disjoncteurs. En effet, le déclenchement en cascade est systématique au détriment du disjoncteur le plus passant. L'opération est totalement impossible avec des relais électromécanique car les écarts de temps d'ouverture et de fermeture détruiraient rapidement les contacts en commençant par le plus lent des relais.

Certains montages permettent d'équilibrer le courant dans plusieurs éléments semi-conducteurs en parallèle comme décrit dans le brevet « US 6 208 041 B1 » (MAJUMDAR GOURAB [JP] ET AL) 27 mars 2001 (2001-03-27), mais ces solutions ne satisfont pas à nos besoins qui sont d'obtenir un contrôle indépendant de chaque élément de disjoncteur dans chacune des tranches. De plus ces solutions ont l'inconvénient de réaliser l'équilibre en limitant la conduction des éléments les plus conducteurs ce qui crée un échauffement et une chute de tension supplémentaire. Enfin ces solutions mettent fin à l'indépendance électrique des tranches, ce qui poserait un problème d'utilisation avec une nouvelle architecture de réseau électrique et les tranches ne pourraient plus constituer les relais décrits dans la demande de brevet déposée ce même jour par le demandeur pour « Nouvelle architecture de réseau électrique pour milieux confinés incorporant des sources électriques. »

La capacité d'ouverture des sous-disjoncteurs indépendants sur chacune des tranches dans la revendication « US 2004/0252430 A1 » (OUMARU TAKESHI [JP] ET AL) 16 décembre 2004 (2004-12-16) n'est pas applicable aux tranches indépendantes définies dans ce document.

EP 0 517 261 A2 décrit un disjoncteur comportant plusieurs tranches, chaque tranche comportant une pluralité de disjoncteurs élémentaires, ledit disjoncteur étant destiné à entraîner une seule charge.

Pour assurer la fonction de protection on fait appel généralement à des éléments de coupure tels que par exemple triacs, thyristors, IGBT (Transistor bipolaire à grille isolée), SSPC (Elément statique de coupure de puissance) etc.

### Exposé de l'invention

### Problème technique

L'inconvénient majeur de ces composants réside dans leur forte impédance ou chute de tension par rapport à des composants électromécaniques. Cette forte impédance et cette chute de tension se traduisent par des échauffements plus importants.

Par exemple les disjoncteurs électroniques de type SSPC montés en étages complémentaires ou symétriques pour le courant alternatif, présentent une chute de tension encore trop élevée par unité de surface de semi-conducteur, d'où un échauffement important quand on utilise ces composants en régime permanent à des valeurs de courant importantes.

Si on considère le cas général d'une distribution électrique primaire, compteur électrique domestique, barre principale de distribution pour un aéronef, un navire ou autre moyen de transport, le courant maximum distribué par le primaire est généralement bien inférieur à la somme des courants de chacune des protections secondaires. Ceci tient au fait que le calibre d'un disjoncteur est supérieur à la consommation de la charge qui y est connectée (on prend au moins une marge de 20%) et d'autre part au fait que les différentes charges ne consomment pas toutes leur maximum de courant en même temps.

Cependant, certaines charges peuvent consommer en permanence un maximum de courant alors que d'autres ont une consommation très en deçà de la valeur du calibre utilisé ou ne sont traversés que par quelques pics de consommation. On observera donc des disjoncteurs en état de surchauffe relativement à d'autres qui resteront froids, il en résultera une répartition très hétérogène des échauffements et par voie de conséquence un surdimensionnement des radiateurs d'autant plus important que l'on cherche à prévoir les cas les plus critiques d'utilisation.

En outre des ventilations forcées peuvent s'avérer nécessaires pour assurer une bonne évacuation de la chaleur dégagée.

De surcroît, le taux de défaillance par SSPC sur une même carte disjoncteur qui en contient plusieurs alimentant des charges différentes, devient très variable et le taux de défaillance de la carte disjoncteur dans son ensemble s'en trouve pénalisé.

Dans le cas plus précis de l'aéronautique sont utilisées des cartes disjoncteur contenant des SSPC
Pour limiter les coûts, il est connu de disposer les SSPC sur une même carte, mais en corolaire cette disposition n'offre aucune souplesse de raccordement et lie entre elles des charges à priori indépendantes sur un plan fonctionnel et en gestion de configuration. Cette solution n'a que peut d'effet sur les problèmes d'échauffement d'un SSPC, elle ne contribue pas à homogénéiser correctement la répartition de la chaleur, puisque chacun des SSPC est dédié à l'alimentation d'une seule charge ou ensemble de charges, même si plusieurs SSPC partagent un même radiateur.

Pour encore limiter les coûts et donner de la souplesse il est connu de pouvoir programmer les seuils de disjonctions. Malheureusement cette solution oblige à définir un élément fusible compatible avec le plus haut calibre de programmation et de dimensionner encore une fois un radiateur afin que ce dernier soit capable d'évacuer de manière optimale la chaleur susceptible d'être dégagée par le courant d'alimentation maximum autorisé pour une charge elle aussi maximum. Cette solution conduit aussi à dimensionner le câblage en fonction de cet élément fusible et donc à augmenter souvent inutilement la masse de ce dernier.

Un autre inconvénient des disjoncteurs connus de l'état de la technique réside dans l'impossibilité de tester leur capacité d'ouverture en cours de fonctionnement pour s'assurer qu'ils ne présentent pas de pannes cachées s'opposant à leur ouverture.

### Solution technique

La présente invention a pour objet de résoudre les inconvénients cités en mettant en oeuvre un nouveau type de disjoncteur permettant une meilleure répartition du dégagement de chaleur.

Un autre but de la présente invention est la mise en oeuvre d'un disjoncteur pour lequel la fonction fusible est adaptée au calibre utilisé.

Un autre but de la présente invention est la possibilité de tester la capacité d'ouverture du disjoncteur en cours de fonctionnement.

A cet effet le disjoncteur est caractérisé en ce qu'il est constitué de plusieurs disjoncteurs élémentaires agencés en au moins une tranche adaptée à alimenter plusieurs charges indépendantes, chaque disjoncteur élémentaire présentant une entrée et une sortie.

Selon une autre caractéristique de l'invention, le disjoncteur comprend au moins deux tranches et l'un au moins disjoncteur élémentaire de chaque tranche est connecté par sa sortie à la sortie d'un disjoncteur élémentaire et d'un seul de l'autre tranche.

Selon une autre caractéristique de l'invention les différents disjoncteurs élémentaires affectés à l'alimentation d'une charge particulière appartiennent de préférence à des tranches différentes.

Grâce à ces dispositions, la chaleur dégagée peut se répartir sur plusieurs tranches ce qui est un facteur d'homogénéité des températures de coeur des composants.

De plus, en raison de ces dispositions, sont utilisés plusieurs disjoncteurs élémentaires pour alimenter une charge, chacun d'entre eux fournissant une partie du courant d'alimentation de la charge. Le nombre de disjoncteurs associés à cette charge, selon une autre caractéristique de l'invention, est déterminé par le calibre de la charge. Ce nombre sera au moins égal au ratio du calibre prévu pour la charge par le calibre d'un disjoncteur élémentaire.

Il sera égal à ce ratio lorsque la programmation des disjoncteurs est effectuée uniquement par voie matérielle et il pourra être supérieur à ce ratio lorsque le calibre des charges sera programmable par voie logicielle.

Selon une autre caractéristique de l'invention, chaque disjoncteur élémentaire possède un calibre prédéfini, ce calibre définissant le déclenchement dudit disjoncteur. Cette disposition permet d'utiliser une fonction fusible par disjoncteur élémentaire prédéterminée et parfaitement adaptée au calibre de ce disjoncteur élémentaire.

Selon une autre caractéristique de l'invention, chaque disjoncteur élémentaire est actionnable à distance dans le sens de l'ouverture ou de la fermeture. Cette disposition permet de tester la capacité d'ouverture de chacun des disjoncteurs élémentaires associés à une même charge de façon séquentielle. En raison de cette ouverture séquentielle, (un seul disjoncteur élémentaire ouvert à la fois) très brève et répétée, l'alimentation de la charge ne s'en trouve pas affectée cette dernière étant alimentée par les autres disjoncteurs élémentaires. La durée de cette ouverture sera de préférence inférieure à 100 millisecondes. Pour ce qui concerne un courant alternatif elle sera de préférence inférieure à une période. Cette durée peut également servir de variable d'ajustement des déséquilibres intrinsèques et extrinsèques des disjoncteurs élémentaires et de leurs connectiques affectées à une même charge.

L'invention à également pour objet une installation comportant au moins un nouveau type de disjoncteur.

Cette installation selon une caractéristique de l'invention possède un moyen de contrôle de l'ouverture de chaque disjoncteur élémentaire de manière séquencée, ledit moyen ouvrant et fermant tour à tour chaque disjoncteur élémentaire d'une même charge.

Selon une autre caractéristique de l'invention, le disjoncteur est caractérisé en ce que :
- il est constitué de plusieurs disjoncteurs élémentaires agencés en au moins deux tranches, chacune électriquement ségréguées, adaptées à alimenter plusieurs charges indépendantes, chaque disjoncteur élémentaire présentant une entrée et une sortie,
- l'un au moins disjoncteur élémentaire de chaque tranche est connecté par sa sortie à la sortie d'un disjoncteur élémentaire et d'un seul de l'autre tranche,
- au moins deux disjoncteurs élémentaires affectés à l'alimentation d'une charge particulière appartiennent à des tranches différentes,
- ledit disjoncteur déclenchant à partir de la somme des informations des différentes tranches.

Chaque tranche de disjoncteur est indépendante électriquement des autres tranches jusqu'à ses sorties permettant en cas de défaillance de l'une d'elles de ne pas affecter les autres tranches et d'assurer une ségrégation électrique avec d'autres tranches connectées à un autre générateur pour l'utilisation des tranches dans le cadre des allocations dynamiques de charge tels que décrit dans la demande de brevet déposée ce même jour par le demandeur pour « Nouvelle architecture de réseau électrique pour milieux confinés incorporant des sources électriques. »

### Description sommaire des figures et des dessins.

D'autres avantages et caractéristiques de l'invention apparaîtront à la lecture de la description d'une forme préférée de réalisation donnée à titre d'exemple non limitatif en se référant aux dessins annexés en lesquels :

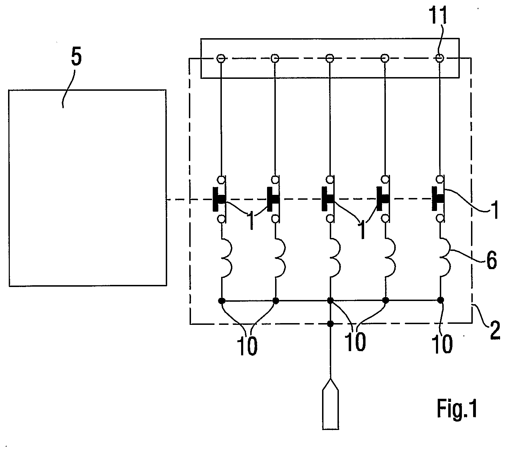

- la figure 1 est une vue schématique d'un disjoncteur conforme à l'invention constitué d'une seule tranche,
- la figure 2 est une vue schématique d'une installation électrique mettant en oeuvre un disjoncteur selon l'invention, comportant plusieurs tranches.

### Meilleure manière de réaliser l'invention

Tel que représenté le nouveau type de disjoncteur est constitué de plusieurs disjoncteurs élémentaires 1 agencés en au moins une tranche 2 adaptée à alimenter une ou plusieurs charges indépendantes 3, chaque disjoncteur élémentaire 1 présentant une entrée 10 d'énergie électrique destinée à être connecté à un conducteur d'un réseau de fourniture d'énergie électrique et une sortie 11 destinée à connectée à une charge 3. Chaque tranche 2 est formée par un seul et même circuit ou dans un seul et même composant ou sur une même tranche de semi-conducteur.

Dans la forme de réalisation représentée aux figures jointes, le disjoncteur selon l'invention alimente plusieurs charges 3 et comprend au moins deux tranches 2, les entrées 10 des disjoncteurs élémentaires 1 de chaque tranche 2 étant reliées électriquement les unes aux autres et étant destinées à être connectées à un conducteur d'un réseau de fourniture d'énergie électrique.

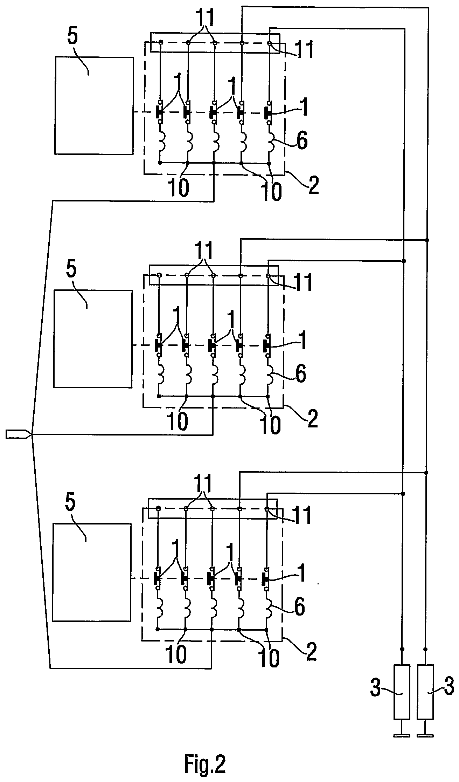

La sortie 11 de chaque disjoncteur élémentaire 1 de chaque tranche 2 est connectée électriquement à la sortie 11 d'un disjoncteur élémentaire de l'autre tranche. Ainsi chaque charge 3 est alimentée par l'intermédiaire de plusieurs disjoncteurs élémentaires 1, ces différents disjoncteurs appartenant à des tranches différentes 2. Dans l'exemple de réalisation objet de la figure 2, chaque charge est alimentée par trois disjoncteurs élémentaires 1 de trois tranches différentes 2.

Alternativement on pourra prévoir qu'au moins deux disjoncteurs élémentaires 1 affectés à l'alimentation d'une même charge 3, appartiennent à une même tranche 2.

Chaque disjoncteur élémentaire 1 possède un calibre prédéfini, préférentiellement non programmable. A chaque disjoncteur élémentaire 1 est associé un élément fusible de protection 6 connu en soi, appartenant ou non à la tranche 2, et dont le calibre est prédéterminé et adapté au calibre du disjoncteur élémentaire 1.

Le nombre de disjoncteurs élémentaires 1 affectés à une charge 3, c'est à dire à son alimentation, est déterminé par le calibre affecté à cette charge 3, la somme des calibres des disjoncteurs élémentaires 1 étant au moins égale au calibre affecté à la charge 3.

Avantageusement, chaque disjoncteur élémentaire 1 est actionnable à distance dans le sens de l'ouverture ou de la fermeture soit par un signal électrique soit par un signal optique délivré par un moyen de gestion et de contrôle 5.

A chaque disjoncteur élémentaire 1 est associé un moyen, non représenté, de mesure de l'intensité du courant qui le traverse. La valeur de l'intensité de ce courant est émise par un moyen de transmission approprié, non représenté, de manière analogique ou numérique, à un moyen de gestion centralisé de la disjonction, commun à tous les disjoncteurs élémentaires d'une même charge, ce moyen pouvant être le moyen de gestion et de contrôle 5. Cette disposition permet au moyen de la gestion centralisée de calculer les déclenchements pour une charge donnée. La gestion centralisée permet de plus de corréler les différentes mesures de courant entre les différentes tranches 2 afin de détecter des erreurs de mesure. La gestion centralisée permet également de déclencher de façon synchrone tous les disjoncteurs élémentaires 1 associés à une même charge 3, en particulier, pour les charges polyphasées, le déclenchement doit intervenir de façon synchrone sur toutes les phases.

A chaque tranche 2 peut être associé un moyen supplémentaire, non représenté, de mesure de l'intensité du courant qui pénètre dans cette dernière.

A chaque disjoncteur élémentaire 1 pourra être associé également un moyen de mesure, non représenté, de la tension à l'une au moins des bornes d'entrée 10 et sortie 11 de chaque disjoncteur élémentaire 1. La valeur de cette tension est émise par un moyen, non représenté, de transmission adapté, de manière analogique ou numérique, au moyen 5 de gestion centralisé de la disjonction, commun à tous les disjoncteurs élémentaires 1 d'une même charge.

Cette disposition permet de déterminer d'autres facteurs de déclenchement ou de contrôle basés sur la tension, de permettre la localisation de défauts et d'analyser le réseau environnant et ses défauts.

Ces différents moyens de mesure de courant et de tension peuvent être externes au composant ou bien internes.

Sur la figure 2 est montrée une installation destinée à l'alimentation électrique d'au moins une charge 3 électrique comportant un disjoncteur en tranches 2 tel que décrit.

Cette installation possède un moyen de contrôle de l'ouverture de chaque disjoncteur élémentaire 1 de manière séquencée, ledit moyen ouvrant et fermant tour à tour chaque disjoncteur élémentaire 1 d'une même charge 3. Cette disposition permet de tester la capacité d'ouverture des disjoncteurs pour chacune des charges.

Ce moyen de contrôle peut avantageusement être constitué par le moyen de gestion 5 de la disjonction précédemment décrit.

Avantageusement, les disjoncteurs élémentaires 1 peuvent constituer les relais décrits dans la demande de brevet déposée ce même jour par le demandeur pour « Nouvelle architecture de réseau électrique pour milieux confinés incorporant des sources électriques. »

Il va de soi que la présente invention peut recevoir tous aménagements et variantes du domaine des équivalents techniques sans pour autant sortir du cadre du présent brevet.

## Revendications

1. Disjoncteur comportant plusieurs tranches (2), dont une première tranche et au moins une deuxième tranche, dans lequel :
- chaque tranche comporte une pluralité de disjoncteurs élémentaires, chacune des tranches étant formée par un seul et même circuit ou dans un seul et même composant ou sur une même tranche de semi-conducteur, et ;
- chaque disjoncteur élémentaire (1) présente une entrée et une sortie, et;
- chaque sortie des disjoncteurs élémentaires peut être connectée indépendamment à une charge, et;
- au moins un disjoncteur élémentaire de la première tranche est connecté par sa sortie à la sortie d'un disjoncteur élémentaire d'au moins une autre tranche, lesdits disjoncteurs élémentaires (1) étant affectés à l'alimentation d'une charge (3) particulière ;
- une gestion centralisée permettant de calculer les déclenchements des disjoncteurs élémentaires affectés à l'alimentation de ladite charge particulière.

2. Disjoncteur selon la revendication 1, dans lequel chaque disjoncteur élémentaire (1) possède un calibre prédéfini.

3. Disjoncteur selon la revendication 2, dans lequel un nombre de disjoncteurs élémentaires (1) affectés à une charge (3) est déterminé par le calibre affecté à ladite charge (3) de sorte que la somme des calibres desdits disjoncteurs élémentaires est au moins égale au calibre attribué à ladite charge.

4. Disjoncteur selon une des revendications 2 à 3, dans lequel au moins deux disjoncteurs élémentaires (1), affectés à l'alimentation d'une même charge (3) appartiennent à la même tranche (2).

5. Disjoncteur selon l'une quelconque des revendications précédentes, dans lequel les entrées (10) des disjoncteurs élémentaires (1) de chaque tranche (2) sont connectées les unes aux autres.

6. Disjoncteur selon l'une quelconque des revendications précédentes, dans lequel chaque disjoncteur élémentaire (1) est actionnable à distance dans le sens de l'ouverture ou de la fermeture.

7. Disjoncteur selon l'une quelconque des revendications précédentes, dans lequel chaque disjoncteur élémentaire (1) est associé un moyen de mesure de l'intensité du courant qui traverse ledit disjoncteur élémentaire et de transmission d'une valeur de l'intensité du courant sous forme analogique ou numérique à un moyen (5) de gestion centralisé de la disjonction, commun à tous les disjoncteurs élémentaires (1) affectés à une même charge (3).

8. Disjoncteur selon l'une quelconque des revendications précédentes, dans lequel chaque disjoncteur élémentaire (1) est associé un moyen de mesure de la tension à l'une au moins des bornes d'entrée (10) et sortie (11) de chaque disjoncteur élémentaire (1) et que la valeur de cette tension est transmise par un de moyen transmission de manière analogique ou numérique à un moyen (5) de gestion centralisé de la disjonction, commun à tous les disjoncteurs élémentaires (1) affectés à une même charge.

9. Disjoncteur selon l'une quelconque des revendications précédentes, dans lequel chaque tranche (2) est associé un moyen de mesure de l'intensité du courant qui pénètre dans ladite tranche.

10. Disjoncteur selon l'une quelconque des revendications précédentes, dans lequel chaque tranche (2) est formée par un seul et même composant.

11. Disjoncteur selon l'une quelconque des revendications précédentes dans lequel les disjoncteurs élémentaires de la première tranche et d'au moins une autre tranche sont raccordés pour alimenter au moins deux charges indépendamment l'une de l'autre.

12. Installation électrique destinée à l'alimentation d'au moins une charge électrique, équipée d'au moins un disjoncteur selon l'une quelconque des revendications précédentes.

13. Installation selon la revendication précédente, comportant un moyen de contrôle de l'ouverture de chaque disjoncteur élémentaire (1) de manière séquencée, ledit moyen ouvrant et fermant tour à tour chaque disjoncteur élémentaire (1) affecté à une même charge (2).

14. Installation selon la revendication précédente dans laquelle la durée de l'ouverture de chaque disjoncteur élémentaire (1) est ajustable.

## Patentansprüche

1. Schutzschalter, der mehrere Segmente (2) umfasst, darunter ein erstes Segment und mindestens ein zweites Segment, wobei:
- jedes Segment eine Vielzahl von elementaren Schutzschaltern umfasst, wobei jedes der Segmente von einer einzigen Schaltung oder in einem einzigen Bauteil oder auf ein und demselben Halbleitersegment gebildet wird/ist und;
- jeder elementare Schutzschalter (1) einen Eingang und einen Ausgang aufweist und;
- jeder Ausgang der elementaren Schutzschalter unabhängig mit einer Last verbunden werden kann und;
- mindestens ein elementarer Schutzschalter des ersten Segments über seinen Ausgang mit dem Ausgang eines elementaren Schutzschalters von mindestens einem anderen Segment verbunden ist, wobei die elementaren Schutzschalter (1) der Versorgung einer bestimmten Last (3) zugewiesen sind;
- wobei eine zentrale Verwaltung ermöglicht, das Auslösen der elementaren Schutzschalter, die der Versorgung der bestimmten Last zugewiesen sind, zu berechnen.

2. Schutzschalter nach Anspruch 1, wobei jeder elementare Schutzschalter (1) eine vordefinierte Größe besitzt.

3. Schutzschalter nach Anspruch 2, wobei eine Anzahl von elementaren Schutzschaltern (1), die einer Last (3) zugewiesen sind, von der Größe bestimmt wird, die der Last (3) zugewiesen ist, sodass die Summe der Größen der elementaren Schutzschalter mindestens gleich der Größe ist, die der Last zugewiesen ist.

4. Schutzschalter nach einem der Ansprüche 2 bis 3, wobei mindestens zwei elementare Schutzschalter (1), die der Versorgung ein und derselben Last (3) zugewiesen sind, zum selben Segment (2) gehören.

5. Schutzschalter nach einem der vorstehenden Ansprüche, wobei die Eingänge (10) der elementaren Schutzschalter (1) jedes Segments (2) miteinander verbunden sind.

6. Schutzschalter nach einem der vorstehenden Ansprüche, wobei jeder elementare Schutzschalter (1) in der Richtung des Öffnens oder des Schließens fernbetrieben werden kann.

7. Schutzschalter nach einem der vorstehenden Ansprüche, wobei jedem elementaren Schutzschalter (1) ein Mittel zum Messen der Stärke des Stroms, der den elementaren Schutzschalter durchfließt, und zum Übertragen eines Werts der Stärke des Stroms in analoger oder digitaler Form an ein Mittel (5) zur zentralen Verwaltung der Schutzschaltung zugeordnet ist, das allen den elementaren Schutzschaltern (1), die ein und derselben Last (3) zugewiesen sind, gemein ist.

8. Schutzschalter nach einem der vorstehenden Ansprüche, wobei jedem elementaren Schutzschalter (1) ein Mittel zum Messen der Spannung an mindestens einer der Eingangs- (10) und Ausgangsklemmen (11) jedes elementaren Schutzschalters (1) zugeordnet ist, und dass der Wert dieser Spannung über ein Mittel zur Übertragung in analoger oder digitaler Weise an ein Mittel (5) zur zentralen Verwaltung der Schutzschaltung übertragen wird, das allen den elementaren Trennschaltern (1), die ein und derselben Last zugewiesen sind, gemein ist.

9. Schutzschalter nach einem der vorstehenden Ansprüche, wobei jedem Segment (2) ein Mittel zum Messen der Stärke des Stroms zugeordnet ist, der in das Segment eindringt.

10. Schutzschalter nach einem der vorstehenden Ansprüche, wobei jedes Segment (2) von einem einzigen Bauteil gebildet wird.

11. Schutzschalter nach einem der vorstehenden Ansprüche, wobei die elementaren Schutzschalter des ersten Segments und mindestens eines anderen Segments so angeschlossen sind, dass sie unabhängig voneinander mindestens zwei Lasten zu versorgen.

12. Zur Versorgung von mindestens einer elektrischen Last bestimmte elektrische Anlage, die mit mindestens einem Schutzschalter nach einem der vorstehenden Ansprüche ausgestattet ist.

13. Anlage nach dem vorstehenden Anspruch, die ein Mittel zum Steuern des Öffnens jedes elementaren Schutzschalters (1) in sequentieller Weise umfasst, wobei das Mittel nacheinander jeden elementaren Schutzschalter (1), der ein und derselben Last (2) zugewiesen ist, öffnet und schließt.

14. Anlage nach dem vorstehenden Anspruch, wobei die Dauer des Öffnens jedes elementaren Schutzschalters (1) einstellbar ist.

## Claims

1. Circuit breaker comprising several segments (2), of which a first segment and at least one second segment wherein:
- each segment comprises a plurality of elementary circuit breakers, with each one of the segments being formed by one and the same circuit or in one and the same component or on the same semi-conductor segment, and;
- each elementary circuit breaker (1) has an input and an output, and;
- each output of the elementary circuit breakers can be connected independently to a charge, and;
- at least one elementary circuit breaker of the first segment is connected by its output to the output of an elementary circuit breaker of at least one other segment, said elementary circuit breakers (1) being assigned to the powering of a particular load (3);
- a centralised management that makes it possible to calculate the triggerings of the elementary circuit breakers assigned to powering said particular load.

2. Circuit breaker according to claim 1, wherein each elementary circuit breaker (1) has a predefined calibre.

3. Circuit breaker according to claim 2, wherein a number of elementary circuit breakers (1) assigned to a load (3) is determined by the calibre assigned to load (3) in such a way that the sum of the calibres of said elementary circuit breakers is at least equal to the calibre assigned to said load.

4. Circuit breaker according to one of claims 2 to 3, wherein at least two elementary circuit breakers (1), assigned to the powering of the same load (3) belong to the same segment (2).

5. Circuit breaker according to any preceding claim, wherein the inputs (10) of the elementary circuit breakers (1) of each segment (2) are connected to one another.

6. Circuit breaker according to any preceding claim, wherein each elementary circuit breaker (1) can be actuated remotely in the direction of opening or of closing.

7. Circuit breaker according to any preceding claim, wherein each elementary circuit breaker (1) is associated with a means for measuring the intensity of the current that passes through said elementary circuit breaker and for transmitting a value of the intensity of the current in analogue or digital form to a means (5) of centralised management of the circuit breaking, common to all of the elementary circuit breakers (1) assigned to the same load (3) .

8. Circuit breaker according to any preceding claim, wherein each elementary circuit breaker (1) is associated with a means for measuring the voltage at at least one of the input (10) and output (11) terminals of each elementary circuit breaker (1) and that the value of this voltage is transmitted by a means of transmission analogically or digitally to a means (5) of centralised management of the circuit breaking, common to all of the elementary circuit breakers (1) assigned to the same load.

9. Circuit breaker according to any preceding claim, wherein each segment (2) is associated with a means for measuring the intensity of the current that penetrates into said segment.

10. Circuit breaker according to any preceding claim, wherein each segment (2) is formed by one and the same component.

11. Circuit breaker according to any preceding claim wherein the elementary circuit breakers of the first segment and of at least one other segment are connected to power at least two charges independently from one another.

12. Electrical installation intended for the powering of at least one electrical load, provided with at least one circuit breaker according to any preceding claim.

13. Installation according to the preceding claim, comprising a means of controlling the opening of each elementary circuit breaker (1) in a sequential manner, said means opening and closing in turn each elementary circuit breaker (1) assigned to the same load (2).

14. Installation according to the preceding claim wherein the duration of the opening of each elementary circuit breaker (1) can be adjusted.
